# EUROPÄISCHE PATENTSCHRIFT

(11) **EP 2 160 932 B1**
(45) Veröffentlichungstag und Bekanntmachung des Hinweises auf die Patenterteilung: **24.08.2011**
(21) Anmeldenummer: 08759117.8
(22) Anmeldetag: 09.06.2008
(51) Int. Cl.: H05K 3/34

(54) **ZWANGSFÜHRUNG EINES VERBINDUNGSMATERIALS**
RESTRAINING A CONNECTING MATERIAL
GUIDAGE FORCÉ D'UN MATÉRIAU DE LIAISON

(30) Priorität: 20.06.2007 DE 102007028811
(43) Veröffentlichungstag der Anmeldung: 10.03.2010
(73) Patentinhaber: Phoenix Contact GmbH & Co. KG, 32825 Blomberg (DE)
(72) Erfinder: BAUMGART, Karsten, 31812 Bad Pyrmont (DE); HELLMIG, Klaus-Dieter, 31812 Bad Pyrmont (DE); REUTER, Georg, 32816 Schieder-Schwalenberg (DE); MÖHLENBEIN, Hermann, 31855 Aerzen (DE)
(74) Vertreter: Bill, Burkart Hartmut
(86) Internationale Anmeldenummer: PCT/EP2008/004586
(87) Internationale Veröffentlichungsnummer: WO 2008/155040

(56) Entgegenhaltungen:
- EP-A- 1 263 272
- US-A- 5 492 266
- US-A- 5 762 259
- US-A1- 2003 166 331
- US-A1- 2005 127 508

## Beschreibung

Die Erfindung betrifft ein Verfahren zum Aufbringen eines Verbindungsmaterials mit einer vorbestimmbaren Form an wenigstens einer Oberfläche wenigstens eines Werkstücks, wobei das Verbindungsmaterial und die Oberfläche komplementäre benetzende bzw. benetzbare Eigenschaften aufweisen sowie ein durch ein solches Verfahren aufbringbares Verbindungsmaterial. Ein derartiges Verfahren ist aus US 5,492,266 bekannt.

Insbesondere auf den Gebieten, die eine Oberflächenmontage- bzw. SMT(Surface Mounting Technology)-Technik zur Bestückung von Bauteilen auf Trägern, wie z.B. Platinen einsetzenden, bestehen häufig Lötverbindungen zwischen metallischen Anschlussstiften und auf einer gedruckten Leiterplatte bzw. PCB (Printed Circuit Bord) ausgebildeten Lötaugen zur mechanischen und elektrischen Verbindung.

Heutzutage wird hierzu auf die meist aus Kunststoff gefertigten Leiterplatten zur Bereitstellung der Lötaugen eine metallische Schicht abgeschieden, die sich mit dem Lot verbinden soll. Damit wird ein Haftverbund zwischen Leitplatte und Lot angestrebt. Da die z.B. durch ein PVD(Physical Vapor Deposition)-Verfahren abgeschiedene galvanische Schicht auf dem Kunststoff jedoch eine geringe Haftfestigkeit aufweist, als z.B. der Anschlussstift an dem Lot, trägt sie kaum zur mechanischen Festigkeit der Lotverbindung bei.

Die an einer vordringenden Lotkante entstehenden Kräfte können nach der Gleichung nach Young, d.h. nach 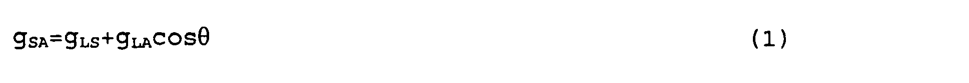 berechnet werden, wobei
g_{SA} die Oberflächenspannung zwischen fester metallischer Werkstückschicht (z.B. Kupfer) und Luft,
g_{LS} die Oberflächenspannung zwischen flüssigem Lot und fester metallischer Werkstückschicht, und
g_{LA} die Oberflächenspannung zwischen flüssigem Lot und Luft ist und θ der Benetzungswinkel ist, der ein Maß für die Benetzbarkeit eines Werkstoffs ist. Bei θ = 0° bedeckt ein Lottropfen die metallischer Werkstückschicht im Wesentlichen als einmolekulare Schicht, wohingegen bei
θ = 180° das flüssige Lot die Gestalt einer Kugel annimmt. Im Rahmen der Erfindung sowie für die nachfolgende Beschreibung und die Ansprüche werde die Begriffe "benetzen(d)" und "benetzbar" in dem Sinne angewandt, dass das benetzende Material das fließfähige und aushärtbare ist und das benetzbare Material während des Benetzungsvorgangs dauerhaft einen festen Zustand einnimt, wobei die jeweiligen Materialeigenschaften, die ein Benetzen bzw. eine Benetzbarkeit ermöglichen komplementär sind, d.h. z.B., dass für eine Lötverbindung das benetzende Material ein Lotmittel ist und das benetzbare Material eine lötbare äußre Schicht besitzt.

Eine Aufgabe der Erfindung besteht darin eine Erhöhung der Haftfestigkeit von über Benetzung bewirkte Verbindungen zu erzielen.

Eine erfindungsgemäße Lösung ist bereits durch die Merkmale eines der anhängenden unabhängigen Ansprüche gegeben. Vorteilhafte und/oder bevorzugte Ausführungsformen sind Gegenstand der abhängigen Ansprüche.

Das Erfindung sieht somit ein Verfahren zum Aufbringen eines Verbindungsmaterials mit einer vorbestimmbaren Form an wenigstens einer Oberfläche wenigstens eines Werkstücks, wobei das Verbindungsmaterial und die Oberfläche komplementäre benetzende bzw. benetzbare Eigenschaften aufweisen, vor. Hierbei wird das Verbindungsmaterial auf die Oberfläche aufgebracht, eine formgebende Einrichtung wird zumindest für die Dauer eines fließfähigen Zustands des Verbindungsmaterials und in der Nähe des Verbindungsmaterials auf die Oberfläche aufgesetzt, wobei die Einrichtung eine in Bezug auf die benetzenden Eigenschaften nicht benetzbare Oberfläche aufweist, so dass der Fluss des noch fließfähigen Verbindungsmaterials im Bereich der nicht benetzbaren Oberfläche zwangsgeführt und somit eine vorbestimmte Form annimmt; und das geformte Verbindungsmaterial ausgehärtet.

Ein Wesentlicher Vorteil der Erfindung liegt darin, dass durch die Geometrie der nicht benetzbaren Oberfläche der formgebenden Einrichtung, das noch nicht umgeschmolzenes Verbindungsmaterial durch die zwangsführende Formgebung orientiert bzw. zielgerichtet an bestimmte Bereiche von benetzbaren Oberflächen zu führen. Hierdurch kann somit auch ein höheres Anfließen an den Flächen der zu insgesamt höherer Haftfestigkeit führenden Verbindungspartner ausgenutzt bzw. erreicht werden. Im Falle von Lötverbindungen hat sich z.B. eine nicht benetzbare Oberfläche, d.h. eine nicht lötbare Oberfläche der formgebenden Einrichtung aus Kunststoff oder Keramik oder eines entsprechenden anderen Materials als zweckmäßig erwiesen, vorteilhafter Weise auch für ein höheres Anfliesen von metallischen Anschlussstiften, die durch eine SMT Lötstelle mit einer gedruckten Leiterplatte verbunden sind.

Weitere Vorteile und Merkmale werden aus der nachfolgenden Beschreibung anhand einer bevorzugten, jedoch lediglich beispielhaften Ausführung unter Bezugnahme auf die beigefügten Zeichnungen ersichtlich. In den Zeichnungen zeigen:
- Fig. 1: stark schematisiert eine Fügeverbindung nach der Erfindung mit einem, eine vorbestimmte Form angenommenen, ausgehärteten Verbindungsmaterial,
- Fig. 2: stark schematisiert eine der Fig. 1 entsprechende Fügeverbindung nach dem Stand der Technik mit einem ausgehärteten Verbindungsmaterial, dass ohne eine zusätzliche Formgebungseinrichtung eine auf den charakteristischen Eigenschaften der benetzenden und benetzbaren Oberflächen beruhenden Form angenommen hat,
- Fign. 3a bis 3c: einzelne Stationen eines beispielhaften Reflow-Verfahrens für die Herstellung einer Fügeverbindung nach dem Stand der Technik,
- Fign. 4a bis 4c: zu den Fign. 3a bis 3c entsprechende Stationen bei der Herstellung einer Fügeverbindung nach der Erfindung,
- Fig. 5: stark schematisiert eine alternative Formgebungseinrichtung, mit Blick auf das auf eine Leiterplatte aufzusetzende Ende,
- Fig. 6: eine zur Fig. 1 alternative Fügeverbindung im Rahmen der Erfindung, und
- Fig. 7: eine weitere zur Fig. 1 alternative Fügeverbindung im Rahmen der Erfindung.

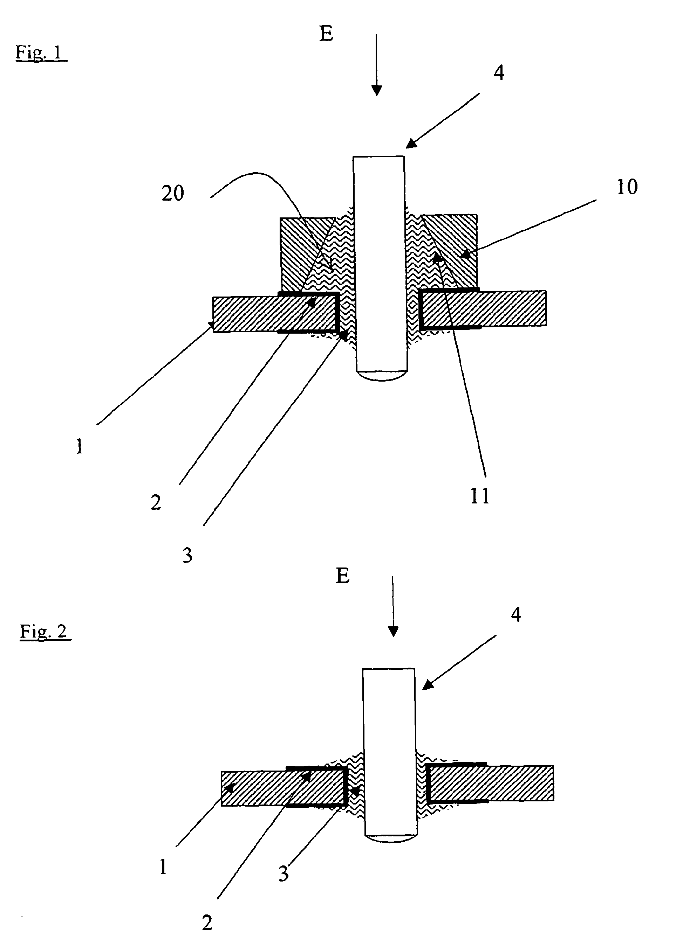

Nachfolgend wird zur beispielhaften Beschreibung bevorzugter Ausführungsformen nach der Erfindung zunächst auf die Fign. 1 und 2 eingegangen, welche der Einfachheit halber stark schematisiert einander entsprechende Fügeverbindungen, im betrachteten Fall Lötverbindungen, zeigen, wobei das Verbindungsmaterial 3 gemäß Fig. 1 nach der Erfindung eine vorbestimmte Form einnehmend ausgehärtet ist bzw. gemäß Fig. 2 ohne eine zusätzliche Formgebungseinrichtung nach dem Stand der Technik eine auf den charakteristischen Eigenschaften der benetzenden und benetzbaren Oberflächen beruhende Form angenommen hat.

Im Einzelnen zeigen Fig. 1 und Fig. 2 jeweils stark schematisiert einen Schnitt durch eine auf Kunststoffmaterial basierende Leiterplatte 1, wobei die Leiterbahnen aus Gründen der Einfachheit nicht dargestellt sind. Auf der Leiterplatte 1 ist eine metallische Schicht 2, beim dargestellten Beispiel aus Kupfer abgeschieden, die mit einer oder mehreren Leiterbahnen elektrisch leitend verbunden ist. Die metallische Schicht bzw. das Lötauge 2 ist in Art einer Durchkontaktierung durch die Leiterplatte geführt. Durch das Lötauge 2 hindurch erstreckt sich ein metallischer Anschlussstift 4 einer nicht näher dargestellten Baugruppe, welcher in Richtung E eingesetzt worden ist.

Die elektrische und mechanische Verbindung des Anschlussstiftes 4 an der Leiterplatte 1 erfolgt mittels des Lötmaterials, welches an dem Lötauge 2 und an dem Anschlussstift 4 aufgebracht ist und sich beim Übergang von einem fließfähigen Zustand in den ausgehärteten Zustand zwischen dem Anschlussstift 4 und dem Lötauge 2 ausgebreitet hat. Das verwendete Lot einerseits und das Lötauge sowie der Anschlussstift andererseits weisen für die hierbei erfolgte Benetzung jeweils komplementäre benetzende bzw. benetzbare Eigenschaften auf.

Wie aus den Fign. 1 und 2 ersichtlich, ist bei der Fügeverbindung gemäß der Erfindung (Fig. 1) zusätzlich eine an der Oberfläche der Leiterlatte, bei Fig. 1 auf dem Lötauge 2 aufgesetzte, formgebende Einrichtung 10 eingesetzt worden. Diese Formgebungseinrichtung 10 weist eine Hohlkegel-artige Öffnung auf, die sich von der Leiterplatte 1 entgegen der Einsetzrichtung E des Anschlussstiftes 4 verjüngt, jedoch zum Anschlussstift hin auch einen Spalt zur Beabstandung definiert.

Zumindest die innere Oberfläche 11 der Formgebungseinrichtung 10 besitzt in Bezug auf die benetzenden Eigenschaften des verwendeten Lots 3 nicht benetzbare Eigenschaften und ist also im betrachteten Fall nicht lötbar.

Die zusätzliche Formgebungseinrichtung 10 bewirkt, dass ein z.B. im Falle eines Reflow-Verfahrens zunächst als Lötpaste an der benetzbaren Oberfläche der Leiterplatte 1 aufgebrachte Lotmaterial, welches durch anschließendes Einsetzen des Anschlussstiftes 4 auch auf dessen Oberfläche aufgebracht wird, sich somit nach Erwärmung und Überführung in einen fließfähigen Zustand entlang des zwischen dem Anschlussstift 4 und des durch die Formgebungseinrichtung 10 definierten Innenraumes 20 sowie entlang des zwischen dem Anschlussstift 4 und des durchkontaktierten Bereichs verbleibenden Spaltes ausbreitet. Zumindest während der Dauer eines fließfähigen Zustandes des Lotmaterials verbleibt die Formgebungseinrichtung 10 somit an der Oberfläche der Leiterlatte angeordnet, wie bei Fig. 1 zu sehen. Nach dem Aushärten des Lotmaterials in der somit zwangsherbeigeführten und folglich eine vorbestimmte Form eingenommen Weise kann anwendungsspezifisch die zusätzliche Formgebungseinrichtung wieder entfernt werden.

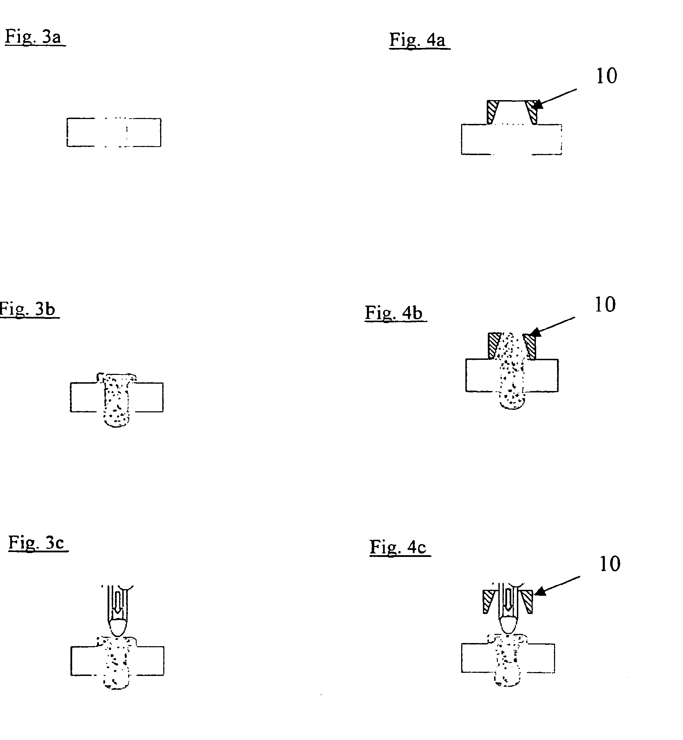

Einzelne Stationen eines solchen beispielhaften Reflow-Verfahrens sind für die Herstellung einer Fügeverbindung gemäß Fig. 2, also nach dem Stand der Technik, den Fign. 3a bis 3e und für die Herstellung einer Fügeverbindung gemäß Fig. 1, also nach der Erfindung den Fign. 4a bis 4c zu entnehmen. Die Fign. 3a und 4a zeigen eine Leiterplatte mit einer metallischen Schicht und hierüber durchkontaktierter Bohrung. Gemäß Fig. 4a ist zusätzlich bereits eine Formgebungseinrichtung 10 auf der "oberen" Leiterplattenoberfläche aufgesetzt.

Die Fign. 3b und 4b zeigen die jeweiligen Anordnungen mit aufgetragener Lotpaste, wobei auch die Bohrung mit Lotpaste gefüllt ist eine Leiterplatte mit einer metallischen Schicht und hierüber durchkontaktierter Bohrung. Gemäß Fig. 4b kann auch das Innere der Formgebungseinrichtung 10 mit Lotpaste gefüllt.

Bei Fign. 3c und 4c wird die Leiterplatte mit einem nicht dargestellten Bauteil bestückt und hierbei ein Anschlussstift in die Bohrung eingesetzt. Gemäß Fig. 4c ist es nach der Erfindung auch möglich, erst bei diesem Schritt die Formgebungseinrichtung 10 auf der "oberen" Leiterplattenoberfläche aufzusetzen.

Beim Einsetzen des Anschlussstiftes drückt dieser daraufhin zunächst die Lotpaste durch die Bohrung hindurch. Anschließend wird das Lot durch einen Reflow-Prozess auf an sich bekannt Weise verflüssigt und das verflüssigte Lot "kriecht" am Anschlussstift wieder in entgegengesetzte Richtung und bildet gemäß Stand der Technik, d.h. ohne die erfindungsgemäße Verwendung einer Formgebungseinrichtung 10, einen charakteristischen Lotkegel gemäß Fig. 2 aus bzw. bei Verwendung einer zusätzlichen Formgebungseinrichtung 10, die durch diese vorbestimmte Form gemäß Fig. 1 aus. Spätestens zum Zeitpunkt, zu dem das Lotmaterial in einen fließfähigen Zustand übergeführt wird, muss somit die Formgebungseinrichtung 10 im Rahmen der Erfindung entsprechend angeordnet sein.

Durch die erfindungsgemäße Verwendung einer Formgebungseinrichtung mit in Bezug zu den benetzenden Eigenschaften des Verbindungsmaterials nicht benetzbaren Eigenschaften kann somit das fließfähige Verbindungsmaterial zwangsgeführt werden und dadurch auch ein höheres Anfliesen am Anschlussstift bewirkt werden. Dieser höhere Anfluss steht im direkten Zusammenhang mit einer größeren benetzten Fläche, wodurch direkt eine erhöhte Haftfestigkeit der Verbindungsstelle ableitbar ist.

Gleichzeitig ist, wie z.B. der Fig. 4b zu entnehmen, auch eine Erhöhung der Lotmenge möglich, so dass die benetzbare Fläche z.B. am Anschlussstift noch weiter benetzt wird. Eine solche höhere Menge an Lot kann z.B. durch eine Stufenschablone oder mittels eines Dispensers aufgebracht werden.

Die nicht benetzbare, zur Zwangsführung des Lots ausgebildete Oberfläche der Formgebungseinrichtung kann allein durch die Materialauswahl bei der Herstellung der Formgebungseinrichtung bewirkt werden und/oder durch den Einsatz von nachträglich an der Oberfläche aufgebrachten Trennmitteln oder entsprechenden benetzungsreduzierenden Stoffen. Auch die Geometrie der nicht benetzbaren Oberfläche der Formgebungseinrichtung, des Lötauges in Zusammenhang mit der spezifischen Form der nicht benetzbaren Oberfläche wirkt auf die erreichbare Haftfestigkeit der Verbindung bei ausgehärtetem Verbindungsmaterial ein.

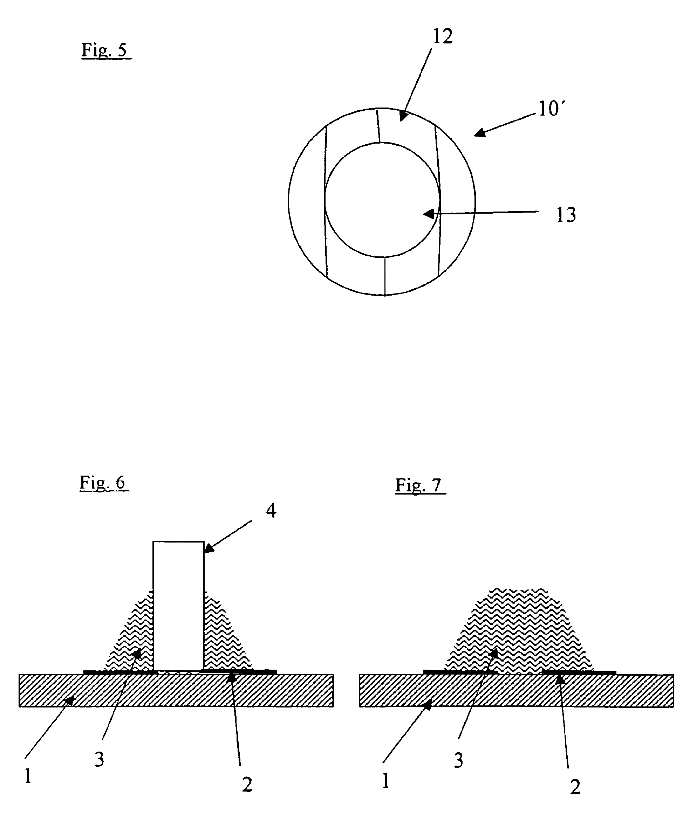

Z.B. hat sich als eine Alternative zu einer Formgebungseinrichtung 10, welche eine lediglich hohlkegelförmige Oberfläche zur Zwangsführung des fließfähigen Verbindungsmaterials bereitstellt, auch eine zylinderförmige Formgebungseinrichtung 10' als besonders zweckmäßig erwiesen, die gemäß Fig. 5 mit einer V-förmigen Nut oder Kerbe 12 ausgebildet ist, welche sich wiederum entgegen der Einsetzrichtung eines Anschlussstiftes verjüngt, und eine innere zylinderförmige Öffnung 13 aufweist, die zum eingesetzten Anschlussstift hin noch einen Spalt zur Beabstandung definiert. Die Fig. 5 zeigt somit eine Aufsicht auf das auf eine Leiterplatte aufzusetzende Ende der erfindungsgemäßen Formgebungseinrichtung 11'.

Alternativ zu der Darstellung nach Fig. 1 kann das Lötauge 2 z.B. auch gemäß Fig. 6 derart ausgebildet sein, dass ein Anschlussstift nicht in die Leiterplatte einzusetzen ist sondern lediglich auf das Lötauge aufzusetzen ist. Das Verbindungsmaterial ist hierbei ausgehärtet und die zusätzliche Formgebungseinrichtung wieder entfernt. Die speziellen Anordnungen von an der Leiterplatte angeordneter metallischer Schicht und Endpunkt eines eingesetzten oder aufgesetzten Anschlussstiftes sind hierbei im Wesentlichen abhängig vom jeweiligen Lötverfahren. Auch ist zum Aufbringen eines Verbindungsmaterials mit einer vorbestimmbaren Form nach der Erfindung der Einsatz eines Anschlussstiftes nicht zwingend, wie z.B. der Fig. 7 zu entnehmen ist. Auch bei Fig. 7 ist eine während eines fließfähigen Zustand des Verbindungsmaterial eingesetzte zusätzliche Formgebungseinrichtung nach Aushärtung des Verbindungsmaterials wieder entfernt worden. Ferner kann die Formgebungseinrichtung 10 oder 10' z.B. auch an einer weiteren Komponente, wie z.B. an einer Leisten-artigen Bauteilkommponente ausgebildet sein, welche eine Vielzahl von Anschlussstiften beherbergt und von einem SMT-Bestückungsautomaten auf einer Bandrolle vorgehalten wird.

Z.b. stellte sich unter Verwendung einer der Fig. 5 ähnlichen Formgebungseinrichtung bei einer runden Lötaugengeometrie, die aus einer 500µm dicken metallischen Schicht hergestellt war, auf welche anschließend Anschlussstifte aufgesetzt wurden nach einem Reflowprozess aus der nachfolgenden Tabelle ersichtliche Werte ein.

| | Lotmenge | Zugfestigkeit |
|---|---|---|
| Standard-Verfahren | 250µm | ca. 60 N |
| Erfindung | 250µm | ca. 90 N |
| Erfindung | 500µm | ca. 110 N |

Die Erfindung ermöglicht somit in definierten Bereichen einer mittels eines fließfähigen, aushärtenden Verbindungsmaterials hergestellten Fügeverbindung einen Anstieg des Verbindungsmaterials an benetzbaren Bereichen vor Aushärtung, so dass die mechanische Festigkeit nach Aushärtung des Verbindungsmaterials erhöht ist. Dies wird erfindungsgemäß grundsätzlich dadurch bewirkt, dass eine typischerweise 360° umlaufende Benetzung durch nicht benetzbare Oberflächen einer zusätzlichen Forgebungseinrichtung so eingeschränkt wird, dass das Verbindungsmaterial im fließfahigen Zustand zwangsgeführt und folglich der verbleibende benetzbare Anteil mehr benetzt wird.

Das erfindungsgemäße Verfahren eignet sich grundsätzlich für bleihaltige aber auch für bleifrei Lote sowie für Klebstoffe und andere fließfähigen Verbindungsmaterialien, die nach einem Aushärten in eine feste Form übergehen und benetzende Eigenschaften besitzen.

## Patentansprüche

1. Verfahren zum Aufbringen eines
Verbindungsmaterials mit einer vorbestimmbaren Form an wenigstens einer Oberfläche wenigstens eines Werkstückst (1), wobei das Verbindungsmaterial und die Oberfläche komplementäre benetzende bzw. benetzbare Eigenschaften aufweisen, mit folgenden Schritten:
das verbindungsmaterial (3) wird auf wenigstens eine der Oberflächen (2) aufgebracht, eine formgebende Einrichtung (10, 10') mit einer Öffnung wird zumindest für die Dauer eines fließfähigen Zustands des Verbindungsmaterials benachbart zum
Verbindungsmaterial sowie dieses wenigstens teilweise umgebend an der Oberfläche (2) angeordnet, wobei diese Einrichtung eine in Bezug auf die benetzenden Eigenschaften des Verbindungsmaterials nicht benetzbare Oberfläche (11, 12) aufweist, die ausgerichtet wird zum Zwangsführen des Flusses des noch fließfähigen Verbindungsmaterials im Bereich der nicht benetzbaren Oberfläche, das somit eine vorbestimmte Form annimmt, wobei zwischen der formgebenden Einrichtung und einem in die Öffnung eingesetzten Anschlussstift (4) ein Spalt definiert und
**dadurch** auch ein höheres Anfließen des Verbindungsmaterials am Anschlussstift bewirkt wird;
und das geformte Verbindungsmaterial wird ausgehärtet.

2. Verfahren nach Anspruch 1, wobei als benetzbare Oberfläche eine löt- oder klebfähige Schicht bereitgestellt wird und mittels eines Lots eine Lötverbindung bzw. mittels eines Klebers als Fügeverbindung eine Klebeverbindung hergestellt wird.

3. Verfahren nach einem der vorstehenden Ansprüche, wobei die durch das Verbindungsmaterial (3) nicht benetzbare Oberfläche (11, 12) der Einrichtung zur Formung des Verbindungsmaterials hohlkegelförmig und/oder mit einer V-förmigen Einkerbung oder ähnlich ausgebildet wird.

4. Ausgehärtetes Verbindungsmaterial (3) mit einer äußeren Form, welche unter Verwendung eines Verfahrens nach einem der vorstehenden Ansprüche vorbestimmbar herstellbar ist.

5. Verwendung einer Formgebungseinrichtung (10, 10') für ein Verfahren nach einem der vorstehenden Ansprüche zur Herstellung eines ausgehärteten und eine durch die Formgebungseinrichtung vorbestimmte Form eingenommenen Verbindungsmaterials.

## Claims

1. Method for applying a connection material with a predeterminable shape to at least one surface of at least one workpiece (1), wherein the connection material and the surface have complementary wetting or wettable properties, comprising the following steps:
the connection material (3) is applied to at least one of the surfaces (2), a shaping device (10, 10') with an opening is disposed on the surface (2) adjacent to the connection material and at least partially surrounding it, at least for the period when the connection material is in a flowable state, wherein this device has a surface (11, 12) which is non-wettable with respect to the wetting properties of the connection material, and which is arranged for the restraint-guidance of the flow of the still flowable connection material in the region of the non-wettable surface, which connection material therefore adopts a predetermined shape, wherein a gap is defined between the shaping device and a terminal pin (4) inserted into the opening, and in this way a greater flow of the connection material against the terminal pin is also effected, and the shaped connection material is hardened.

2. Method as claimed in claim 1, wherein a solderable or adhesive layer is provided as a wettable surface, and a solder connection is produced by means of a solder, or an adhesive connection is produced by means of an adhesive as a joint connection.

3. Method as claimed in any one of the preceding claims, wherein the surface (11, 12) of the device for shaping the connection material, this surface being non-wettable by the connection material (3), is formed as a hollow cone and/or with a V-shaped notch or the like.

4. Hardened connection material (3) with an outer shape which can be produced in a predeterminable manner using a method as claimed in any one of the preceding claims.

5. Use of a shaping device (10, 10') for a method as claimed in any one of the preceding claims for producing a hardened connection material which has adopted a shape predetermined by the shaping device.

## Revendications

1. Procédé pour appliquer un matériau de liaison présentant une forme pouvant être prédéfinie sur au moins une surface d'au moins une pièce (1), le matériau de liaison et la surface présentant des propriétés réticulantes et/ou réticulables complémentaires, présentant les étapes suivantes :
le matériau de liaison (3) est appliqué sur au moins l'une des surfaces (2), un dispositif (10, 10') de formage doté d'une ouverture est disposé au moins pour la durée d'un état fluide du matériau de liaison à proximité du matériau de liaison et, en entourant au moins partiellement ce matériau, sur la surface (2), ce dispositif présentant une surface (11, 12) qui ne peut pas être réticulée par rapport aux propriétés réticulantes du matériau le liaison, laquelle surface est orientée pour le guidage forcé du flux du matériau de liaison non fluide dans la zone de la surface non réticulable, qui prend ainsi une forme prédéfinie, une fente étant définie entre le dispositif de formage et une broche de raccordement (4) insérée dans l'ouverture et une arrivée d'écoulement supérieure du matériau de liaison sur la broche de raccordement étant également ainsi entraînée ;
et le matériau de liaison formé est durci.

2. Procédé selon la revendication 1, une couche brasable ou adhésive étant mise à disposition comme surface réticulable et une liaison par brasage étant établie au moyen d'un métal d'apport et/ou une liaison collée étant établie au moyen d'une colle sous forme de liaison d'assemblage.

3. Procédé selon l'une quelconque des revendications précédentes, la surface (11, 12), qui ne peut pas être réticulée par le matériau de liaison (3), du dispositif destiné à former le matériau de liaison étant conçue sous forme de cône creux et/ou avec une entaille en V ou similaire.

4. Matériau de liaison (3) durci présentant une forme extérieure, qui peut être fabriquée de façon prédéfinissable en utilisant un procédé selon l'une quelconque des revendications précédentes.

5. Utilisation d'un dispositif de formage (10, 10') pour un procédé selon l'une quelconque des revendications précédentes pour la fabrication d'un matériau de liaison durci et présentant une forme prédéfinie par le dispositif de formage.
